# EUROPEAN PATENT APPLICATION

(11) **EP 4 435 608 A1**
(43) Date of publication of application: **25.09.2024**
(21) Application number: 24162866.8
(22) Date of filing: 12.03.2024
(51) Int. Cl.: G06F 11/26, G06F 11/36

(54) **METHOD AND SYSTEM FOR DYNAMIC AND AUTOMATIC DEVELOPMENT CONFIGURATION FOR A VEHICLE**

(30) Priority: 22.03.2023 US 202363453900 P
(71) Applicant: BlackBerry Limited, Waterloo, Ontario N2K 0A7 (CA)
(72) Inventor: AGRAWAL, Anish, Waterloo, N2K 0A7 (CA); FERGUSON, Geordon Thomas, Waterloo, N2K 0A7 (CA)
(74) Representative: Murgitroyd & Company

(57) **Abstract**

A method at a computing device, the method including receiving an indication of a desired test environment; accessing a configuration catalog to obtain configuration information for the desired test environment; configuring a test node based on the configuration information; obtaining test signals for the desired test environment; and performing testing on the configured test node using the test signals.

## Description

### FIELD OF THE DISCLOSURE

The present disclosure relates to distributed systems, and in particular development environments for a distributed system.

### BACKGROUND

Modern vehicles have differing processors, control units, sensors and other computing nodes. Such sensors may be distributed within the various computing nodes on the vehicle, where each computing node may have access to zero, one or more sensor drivers. Such sensor node may further have different manufacturers and operate using different operating systems. Different vehicle manufacturers may use different hardware and software configurations.

Sensors, or groups of sensors, may be used to generate information that could be useful to one or more applications. Such information is referred to herein as an insight.

Software may be developed to leverage such insights. However, for prototyping and safety reasons, development and testing may need to occur off a real vehicle.

### SUMMARY

Accordingly there is provided a method, a device, and a computer program as detailed in the claims that follow.

### BRIEF DESCRIPTION OF THE DRAWINGS

The present disclosure will be better understood with reference to the drawings, in which:
**Figure 1** is a block diagram showing an example computing node within a computer system.
**Figure 2** is a block diagram showing a system for used with the embodiments of the present disclosure.
**Figure 3** is a block diagram showing an example system for providing insights using synthetic sensors.
**Figure 4** is a block diagram showing a developer and an emulation node capable of being configured for a particular vehicle.
**Figure 5** is a block diagram showing an example vehicle configuration.
**Figure 6** is a block diagram of a developer node and hardware from a vehicle.
**Figure 7** is a process diagram showing a process for configuring a node and testing a synthetic sensor.
**Figure 8** is a block diagram of a simplified computing device capable of being used with the embodiments of the present disclosure.

### DETAILED DESCRIPTION OF THE DRAWINGS

The present disclosure provides a method at a computing device comprising: receiving an indication of a desired test environment; accessing a configuration catalog to obtain configuration information for the desired test environment; configuring a test node based on the configuration information; obtaining test signals for the desired test environment; and performing testing on the configured test node using the test signals.

The present disclosure further provides a computing device comprising: a processor; and a communications subsystem, wherein the computing device is configured to: receive an indication of a desired test environment; access a configuration catalog to obtain configuration information for the desired test environment; configure a test node based on the configuration information; obtain test signals for the desired test environment; and perform testing on the configured test node using the test signals.

The present disclosure further provides a computer readable medium for storing instruction code, which, when executed by a processor of a computing device cause the computing device to: receive an indication of a desired test environment; access a configuration catalog to obtain configuration information for the desired test environment; configure a test node based on the configuration information; obtain test signals for the desired test environment; and perform testing on the configured test node using the test signals. In some embodiments the computer readable medium may be non-transitory.

In a modern vehicle, information from one or more physical sensors may be processed to create an "Insight" that may be valuable in a system. Such one or more physical sensors and the processing associated therewith may be referred to logically as a micro-service or a Synthetic Sensor (SS). The terms micro-service and Synthetic Sensor are used interchangeably herein.

Synthetic Sensors may exist in other types of applications, including but not limited to medical applications, manufacturing applications, Internet of Things applications, among others, and the present disclosure is not limited to vehicle applications. Vehicle applications are provided for illustration below.

Insight is the term used herein to describe any computer created interpretation of basic sensor data. Insights can be as straightforward as data aggregation or correlation or as complex as artificial intelligence and machine learning. For example, a temperature sensor providing high and low watermarks for notification may be considered an "insight". For location services, geofencing is an insight. For cameras, occupant recognition may be an insight. The use of a combination of sensors such as temperature sensors and cameras, may be used with an artificial intelligence model to determine whether a car seat is occupied in a hot vehicle, which may be an insight. Many other examples of insights are possible.

In one embodiment, the vehicle applications may be implemented in a system providing consistent access to vehicle data and intelligent insights in a way that is familiar and accessible to developer communities. Such environment may allow cloud developers to extend their reach to the edge within the vehicle through the development of Synthetic Sensors which derive intelligent insights on vehicle data using common cloud development technologies and paradigms. Such environment may provide consistent access to vehicle data such that Synthetic Sensors can be written and deployed to a broad vehicle base without bespoke custom ization.

Specifically, using abstraction allows for similar data to be provided to a synthetic sensor, while the hardware and software on each vehicle may differ from that of other vehicles. Some vehicles may be configured with certain sensors, hardware, Electronic Control Units (ECUs), or operating systems (OSs) that may not be present in other vehicles.

In this regard, even though the synthetic sensors are meant to be OS, hardware, ECU and vehicle configuration agnostic, they may not run the same on each hardware component. Therefore, it would be beneficial to test such software on a plurality of platforms prior to deploying the software. In particular, it would be useful to developers to be able to test on a variety of vehicle configurations with a specific set of signals (e.g. test signals) and to be able to test with a realistic set of data for those signals. Without such capability, the developer may not be able to confirm whether their synthetic sensor can work with the desired vehicle configuration.

Thus, in accordance with the embodiments of the present disclosure, a developer is assisted in testing for a desired vehicle configuration and test data in a seamless way, in some cases without getting access to real vehicle hardware and live data.

In particular, in accordance with the embodiments of the present disclosure, a preconfigured virtual environment is provided for developers to be able to develop and validate synthetic sensors without having to set up a local development environment. Specifically, such virtual environment may exist in the cloud or on a network server in some embodiments. In case there are updates to the vehicle configuration and test data, the virtual environment in the cloud or on the server enables the developer to access the latest information in a timely manner.

Further, in some embodiments, a set of configurations for a variety of vehicles and a set of test data and/or signals for each of those vehicle configurations may be provided.

Once the above items are prepopulated in the virtual environment, a developer can specify which vehicle they want to test with.

As the developer is ready to deploy their synthetic sensor, the simulation environment may be configured to mimic the selected vehicle configuration and ingest test data in a seamless way. In this way, the synthetic sensor can be validated using the desired configuration and test data/signals without developers having access to a real vehicle or live data.

Further, the embodiments of the present disclosure allow for ability for third party developers to submit their synthetic sensors to a vehicle manufacturer, where the vehicle manufacturer can then validate the submissions automatically using their vehicle's configuration. In this way, the vehicle manufacturer can approve the submissions with confidence that the synthetic sensor will work on their vehicles.

### Example Vehicle System

The present disclosure will be described with regard to an automotive system with nodes. However, this is merely provided for illustration purposes and the methods and systems described herein could equally be used with any other systems.

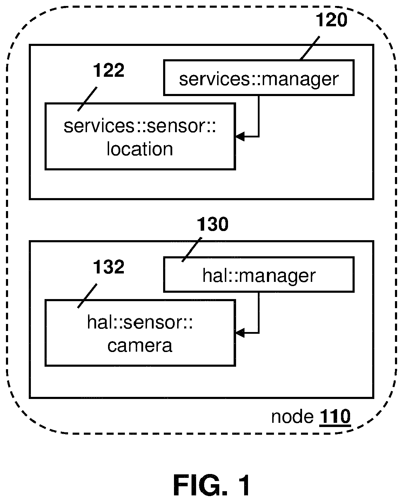

For example, reference is now made to **Figure 1** which shows a node **110.** A node, as used herein, may be one or a group of electronic control units, central processing units, or kernel controls, among other options, and can be considered as a single computing unit.

In the example of **Figure 1****,** node **110** includes a services manager **120** which may interact with drivers for sensors that the node is connected to. For example, the node **110** may have access to a location sensor such as a Global Positioning System (GPS) chipset, as shown at block **122.**

In order to allow node **110** to interact with modules on other nodes, and to provide functionality with a computing system, a Hardware Abstraction Layer (HAL) may be provided on node **110,** which comprises a HAL service **130.** Each HAL service **130** is responsible for the integration of a sensor and may provide various functions, including: integration to the underlying sensor; normalization of the sensor data; and/or, if required, providing a barrier between the safety certified and non-certified software. Other functions for the HAL service are also possible.

In the example of **Figure 1****,** the HAL is provided for camera information, as shown with block **132.**

While the example of **Figure 1** shows a node **110** with a single service and a single HAL, this is merely provided for illustration purposes. A node **110** could have a single service without a HAL, a single HAL without a service, a plurality of services with no HAL, a plurality of HALs with no service, and/or a combination of services and HALs.

One example of a system that could use node **110** would be an applications development environment for vehicles. Such applications development environment may develop applications for user experience including comfort, navigation, infotainment, among others, applications for safety, applications for fleet management; applications for performance monitoring; or other such applications for a vehicle environment. In particular, vehicles provide a plurality of sensors and different makes, models or brands may use different sensors with different data formats or values, creating fragmented sensor readings depending on such sensor. This fragmentation impedes the fostering of an application ecosystem that makes use of vehicle data. In addition, low level sensor data is often too granular to be readily useful to applications.

In this regard, the Hardware Abstraction Layer can be used to provide hardware independent sensor interfaces/abstractions which may encapsulate interaction with underlying sensor drivers. The use of the hardware abstraction in the various computing nodes creates a platform that is extensible, can provide barriers between modules to, for example, enforce safety certified systems being separate from other systems, among other options.

Applications do not interact directly with sensor hardware to access sensor data, instead they leverage the Hardware Abstraction Layer. This separation provides a clear distinction between the responsibilities of the HAL (sensor integration and normalizing sensor data) and other abstractions such as a Vehicle Abstraction Layer (VAL), used for managing access to vehicle data and providing value-added insights.

Specifically, insights may leverage sensor data from multiple HALs in order to provide vehicle abstraction and value-added insights. Vehicle insight services in the VAL may control access to a normalized form of vehicle data and provide value-added inferences. Examples of insight services may include a Location Service, which may provide coordinate location data in a consistent format as well as insights such as geo-fencing; a Seat Service, which may provide a myriad of seat information such as belt status, weight, position, and child lock status; a Camera Service which may provide the video stream for in-cabin camera and possibly functions such as conversions and/or clipping; a Battery Service which may provide insights and access to battery such as charge state/consumption/projected hours remaining/projected range; a Door Service which may provide an abstraction for vehicle doors and door status; among others.

Insight Services may leverage sensor data from multiple HALs in order to provide vehicle abstraction and value-add insights. Higher level insights on data enable application developers to create future automotive experiences. Insight is the term used to describe any value-added interpretation of basic sensor data. Insights can be as straightforward as data aggregation or correlation or as complex as artificial intelligence and machine learning. For example, for a temperature sensor, providing high and low watermarks for notification may be considered an "insight". For location services - geofencing is an insight, for cameras - occupant recognition may be considered an insight.

Nodes with services and HAL managers as described in **Figure 1** are therefore needed for such application development environment. Node **110** will, in many systems, need to communicate with other nodes, such as other ECUs, CPUs, or computing systems, where such ECUs, CPUs, or computing systems may use a different operating system from that of node **110.**

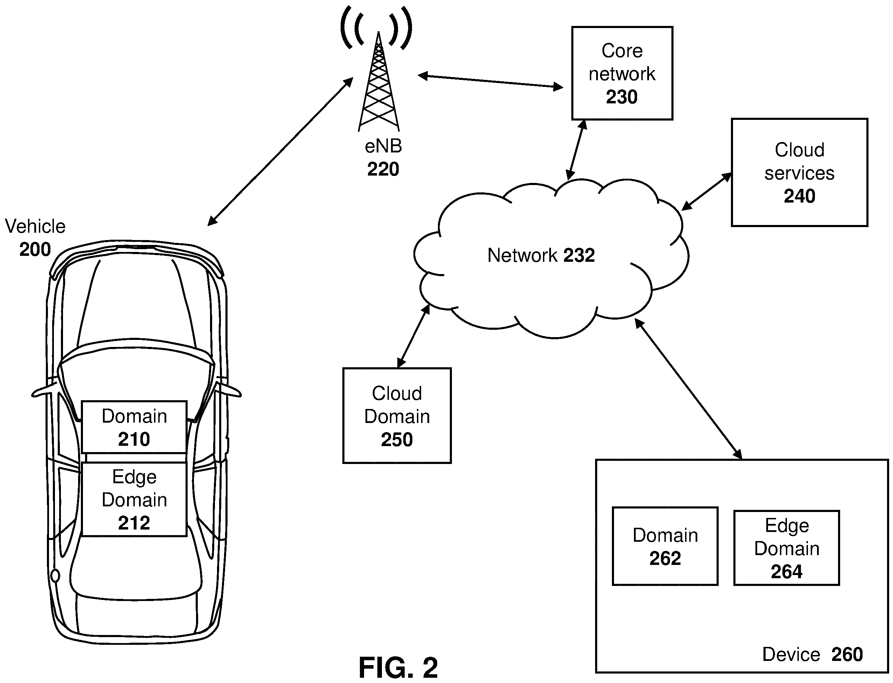

Reference is now made to **Figure 2****,** which shows an example deployed system showing various generators and consumers of insights. The embodiment of **Figure 2** is merely provided for illustration purposes, and in some cases fewer participants in a system will exist. In other cases, more participants in a system will exist.

In the embodiment of **Figure 2****,** a vehicle **200** may be equipped with a computing system and a communications system. Part of the computing system may include a domain **210**, which, as described below, may have applications that consume insights. Further, part of the computing system on vehicle **210** may include an edge domain **212.** In some embodiments, edge domain **212** may generate insights. However, in other cases, insights may be generated within domain **210** or consumed within edge domain **212.**

In the example of **Figure 2****,** vehicle **200** communicates utilizing a communications system with an access point, such as a cellular base station, shown in **Figure 2** as eNB **220.** The base station may communicate with a core network **230** which may then forward communications through a network **232** to a cloud services provider **240.** Network **232** may, for example, be a wide area network such as the Internet.

In other embodiments, rather than a core network **230,** any technology associated with a particular cellular or wireless communications protocol may be used.

In some embodiments, cloud services **240** may provide developer Software Development Kits (SDKs), edge node interfaces, among other services.

In some embodiments, a cloud domain **250** may generate or consume insights. Cloud domain **250** may communicate through network **232** with a cloud services provider **240** and may communicate with other domains such as domain **212** on vehicle **200** in some cases.

Further, rather than a vehicle, a device **260** may consume insights. Device **260** may be any computing device capable of generating or consuming such insights, and could include Internet of Things devices, mobile devices, medical equipment, vehicles or equipment associated with vehicles, among other options. Device **260** may communicate through network **232** utilizing various wired or wireless technologies, including but not limited to Ethernet, fiber, cellular, Wi-Fi, satellite, among other options.

Device **260** may include a domain **262** which may, in some embodiments, consume insights. Further, device **260** may include an edge domain **264** which may, in some cases, generate insights. However, in other cases, domain **262** may generate insights and edge domain **264** may consume insights.

Further, while the embodiment of **Figure 2** shows only two domains within vehicle **200** or device **260,** in practice only one or many domains may exist within the vehicle **200** or the device **260,** and the present disclosure is not limited to only having two domains within any particular device. In particular, a device **260** may be solely used for generating insights, in which case it will have only a single domain. In other cases, device **260** may solely consume insights and again have only one domain. In other cases, a device **260** or vehicle **200** may have a plurality of domains along with edge domain **212.**

In some embodiments, device **260** could be a developer device for the creation of insights for the system.

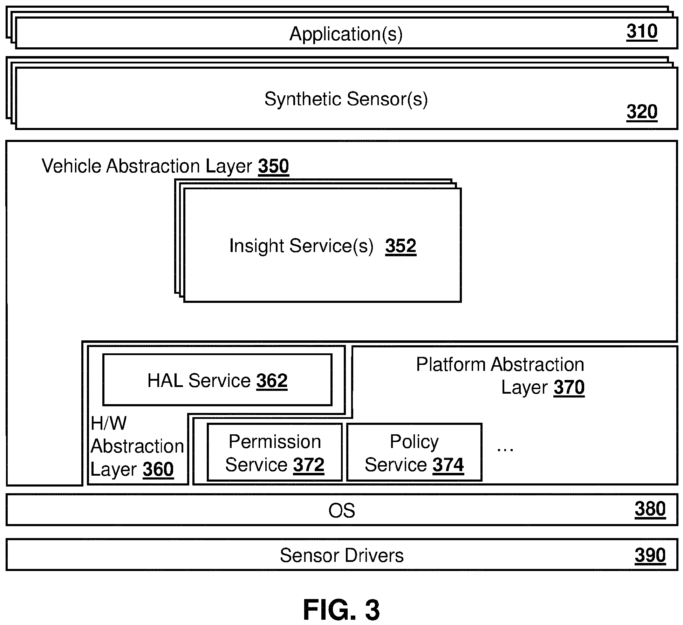

Each domain or edge domain may have an architecture that is OS-agnostic. Specifically, the domains shown in **Figure 2** may be implemented on a variety of domains, where different domains may have different operating systems. For example, in vehicle systems, different vehicle manufacturers may use different operating systems. Therefore, a system architecture for an edge domain may use abstraction layers to allow the system to be implemented on different platforms. Reference is now made to **Figure 3****.**

In the embodiment of **Figure 3****,** applications **310** may be part of an applications layer. An application may in some cases be user facing and utilize synthetic sensors **320** to obtain insights.

Synthetic sensors **320** are part of a synthetic sensor framework. In particular, developers may use the synthetic sensor framework to build synthetic sensors. The framework exposes mechanism to define actions for lifecycle events, services for request/response application program interface (API), among other actions.

The framework of **Figure 3** may further define mechanisms for authentication and authorization of requests and events based on policies. When the synthetic sensor is installed/uninstalled/updated, an Install & Update Service may interact with a Permission Service to update the authentication and authorization policies.

Synthetic sensors **320** may communicate, for example, through an interface with a vehicle abstraction layer (VAL) **350.** Vehicle abstraction layer **350** provides insightful, value-added interfaces for access to vehicle data. It accesses sensor drivers and hardware via a hardware abstraction layer **360.**

The vehicle abstraction layer **350** further provides access insights based on vehicle data. Insights are inferences based on the vehicle data and may be as simple as aggregation or as complex as a machine learning model. For example, a Location Insight Service may provide coordinate location data as well as higher level insights such as geofencing.

Insights may therefore be provided as part of insight services **352** in the embodiment of **Figure 3****.** Such insight services **352** control access to a normalized form of vehicle data and provide value added inferences.

Insight Services generally do not interact directly with sensor hardware to access sensor data, instead they leverage the hardware abstraction layer **360.** This separation provides a clear distinction between the responsibilities of the hardware abstraction layer **360** (sensor integration and normalizing sensor data) and the vehicle abstraction layer **350** (managing access to vehicle data and providing value-add insights).

Insight services **352** may leverage sensor data from multiple hardware abstraction layers in order to provide vehicle abstraction and value-add insights. Synthetic sensors **320** may generate further insights based on the insights/inferences provided by the insight services **352.** In some cases, a synthetic sensor may generate further insights based on the insights provided by another synthetic sensor.

The hardware abstraction layer (HAL) **360** is focused on the integration of sensors, the normalization of sensor data, and is a barrier between safety certified and non-certified software. This may be done through HAL services, where each HAL service **362** may provide three key functions, namely integration to the underlying sensor; normalization of the sensor data; and, if required, providing a barrier between the safety certified and non-certified software
Further, returning to insight service **352,** one of the key functions of the insight service is to enforce access control to normalized sensor data and insights. In order to validate the authentication and authorization of service clients the vehicle abstraction layer services leverage the policy service **374** and Permission Service **372** from the platform abstraction layer **370.**

While the hardware abstraction layer discussed above describes hardware integration, the platform abstraction layer (PAL) **370** encapsulates key aspects of the underlying operating system **380** and platform that allow the system to be ported to different platforms by: defining consistent interfaces to key platform functionality; encapsulating underlying OS specifics into an OS binding component; and supporting high-level/course-grained abstractions beyond the rudimentary OS capabilities.

PAL interfaces are exposed both internally to the HAL and VAL and externally to clients such that the power and portability of these components is extended to clients.

The PAL **370** may have various services. A Permission Service **372** and a policy service **374** are shown in the embodiment of **Figure 3****.** In some cases, other services such as a lifecycle service, a process service and an install and update service may further be provided.

In particular, policy service **374** is responsible for persisting policy values; performing policy queries; notifying policy changes; resolving policy priority; and controlling policy modification. Policies here deal with configuring the behavior of various components, and each policy may have a unique name, a string encoded configuration value, and a priority.

Permission service **372** is the central authority for the domain permissions. Service capabilities that are protected by a permission leverage the Permission Service in order to determine whether the appropriate permissions have been granted or not. In one embodiment, the permission system authentication is underpinned by the Portable Operating System Interface (POSIX) process user and group assignments (UID/GID). The Permission Service identifies/authenticates components based on the UID assigned to their process in the underlying operating system. This UID is carried by the underlying operating system and is deemed legitimate (accessed and managed by the underlying OS using proven/trusted schemes).

For the development of synthetic sensors for the systems of **Figures 1** to **3****,** testing such sensors using various vehicle configurations and a set of test data for such vehicle configurations is beneficial.

### Testing Tool

In accordance with the embodiments of the present disclosure, a mapping tool that is capable of simulating data is provided. In particular, while the tools used to develop synthetic sensors and insights are meant to be hardware agnostic, in reality different vehicles have different sensors, different sets of available signals, some vehicles may have hardware acceleration, while other rely on processors, among other differences, which may affect how things run. In this regard, the tools aim to be able to allow developers to build out their synthetic sensors and insights without worrying about the differences. However, at some point the developers need to be able to test the software on a variety of vehicle hardware and software types.

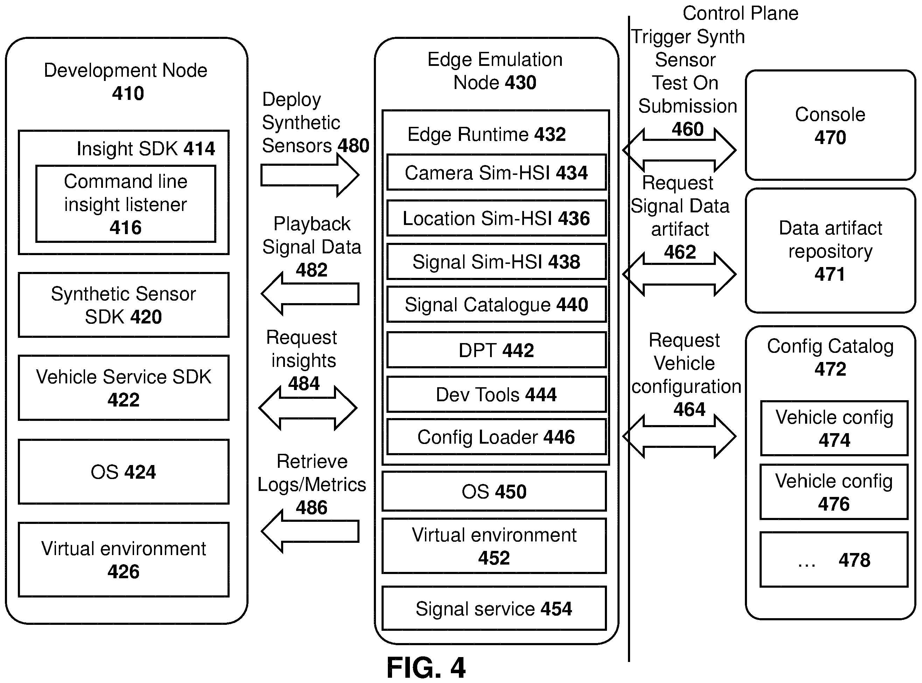

In this regard, reference is now made to **Figure 4**. In the embodiment of **Figure 4****,** a development node **410** may include various software development kits, including an insight software development kit (SDK) **414,** a synthetic sensor software development kit **420,** a vehicle service software development kit **422,** among others. These software development kits allow for developers to create software for systems using the environment described above with regard to **Figures 1** to **3****.**

Optionally, the insight SDK **414** may have a command line insight listener **416,** which may be used to listening to insight signals in the edge emulation node **430.**

The development node **410** may run an operating system **424,** and may in some cases include a preconfigured virtual environment module **426** which may utilize configuration catalogues, as described below.

The code created at development node **410** may be tested on an edge emulation node **430.** In particular, the edge emulation node **430** includes an edge runtime module **432** which includes various hardware abstraction layer service implementations (HSIs), including a camera simulator HSI **434,** a location simulator HSI **436,** a signal simulator HSI **438.** Further, the runtime **432** may include a signal catalog **440,** a data playback tool (DPT) **442** and development tools **444.**

As provided below, the edge runtime **432** may further include a configuration loader **446** that may be used in particular to load the specific configuration signals.

In one embodiment, the configuration loader **446** may be used to configure the camera SIM HSI **434,** location SIM HSI **436** and signal SIM HSI **438** to the signals that the vehicle being tested would utilize in the real world.

Further, the edge emulation node **430** may include an operating system **450.** In one embodiment, the operating system **450** could be configured based on the operating system used in the actual vehicle, as found from a configuration catalog.

Further, a virtual environment **452** is provided within edge emulation node **430.** The virtual environment **452** may be used to configure the edge emulation node **430** to be similar to or the same as the configuration of an actual vehicle. In this regard, the virtual environment **452** could be used to specify that a certain type of hardware, certain hardware accelerators among other aspects, are configured for the edge emulation node **430.** As the edge emulation node **430** may be a cloud service, the particulars of the hardware, hardware acceleration among others could be configured within the cloud services. In this way, edge emulation node **430** may mimic the actual vehicle that is being tested.

A signal service **454** is configured to apply a signal catalog from a vehicle configuration.

In the embodiment of **Figure 4****,** within the control plane of the edge emulation node **430,** various signals could be provided to or sent from a console **470** including a trigger for testing a synthetic sensor **460.** Further, a request for signal data artifacts **462** may be made to a data artifact repository **471.** For example, the developer can submit a command on the console to trigger the test on the edge emulation node. As will be appreciated by those in the art, the signal data artifacts could provide signal data for actual testing, and include the actual signals that a test vehicle would provide for a particular route, situation, or test.

Example of such signal data could, for example include ignition on/off signals, signals regarding door lock status, signals regarding window position status, signals regarding interior temperature if available, signals regarding seatbelt engagement, signals regarding motion within the vehicle, signals regarding sound in the vehicle, among others, which may be combined to make a determination about whether a child seat is occupied and the vehicle is off/doors are locked, etc. As will be appreciated by those in the art, different vehicles may provide different signal sets and therefore it would be beneficial to ensure that the synthetic sensor detects an occupied child seat in a specific vehicle by using the signals that would actually be present in such vehicle.

Further, a configuration catalog **472** could have a plurality of vehicle configurations for different makes, models, and/or builds of vehicles. This is shown in the example of **Figure 4** as a vehicle configuration **474,** vehicle configuration **476** and a vehicle configuration **478.**

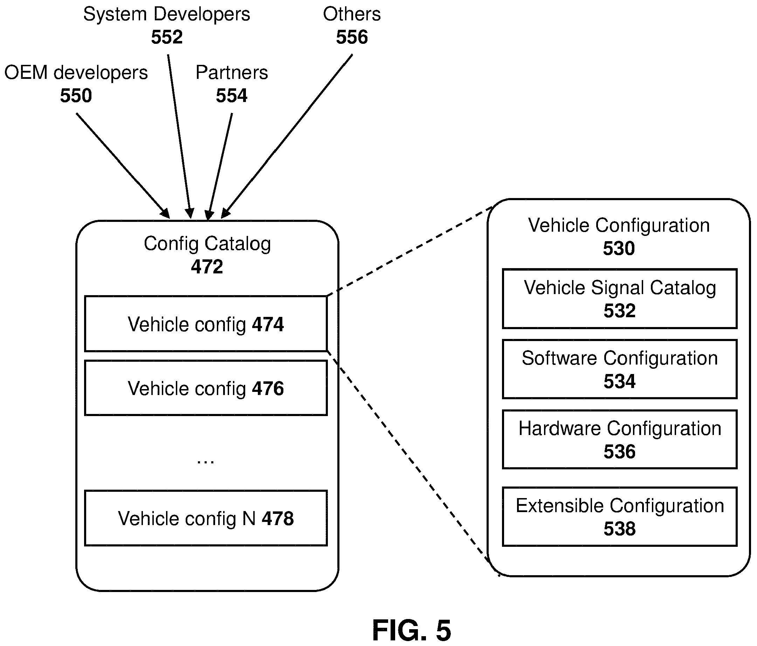

In particular, the configuration catalog **472** is shown in more detail in the embodiment of **Figure 5****.** For example, the configuration catalog **472** includes a vehicle configuration **474.** The vehicle configuration **474** is shown expanded as vehicle configuration **530** and includes vehicles signal catalog **532** which provides signal data for that particular vehicle.

Specifically, vehicle signal catalog **532** describes the set of signals and vehicle data items that are available on a particular vehicle. For example, the name, description, data types, units, restrictions, among other such vehicle data items may be provided in this catalog. The signal configuration would allow the edge emulation node to be configured to mimic the exact set of vehicle data available to synthetic sensors to a particular vehicle.

Vehicle configuration **530** further includes software configuration **534** which includes particulars about the software on the system, including the operating system, the version of the operating system, and other software configurations. For example, this may include the particular version of the synthetic sensor software that is running, the set of machine learning runtime frameworks available on the vehicle, such as Open Neural Network Exchange (ONNX), TensorFlow Lite (TFLite), Snapdragon Neural Processing Engine (SNPE), among others, or other software on the vehicle.

Vehicle configuration **530** further may include a hardware configuration **536** which may include the particulars of the chipset found on the vehicle, the number of processing cores, whether hardware accelerators are being used, other such hardware configurations. Thus, the hardware configuration **536** may define the set of hardware resources available on a particular vehicle. The hardware configuration describes the particular vehicle's available hardware allowing different target nodes to approximate the vehicle as closely as possible. For example, this may include what System on Chip (SoC) is used, how much memory and/or Central Processing Unit (CPU) has been allocated to the synthetic sensor system, among other configurations. Such hardware configurations may be of particular significance to machine learning acceleration in which CPU processing is often offloaded to Graphic Processing Units (GPUs) and Digital Signal Processors (DSPs) when available. The hardware configuration may describe what additional hardware is available in a particular vehicle including GPUs and DSPs, among others. The hardware configuration **536** may allow edge emulation node **530** to be able to allocate or virtualize hardware on the fly that best approximates what is available on a particular vehicle.

Further, extensible configuration **538** allows for the vehicle configuration to be extensible over time, allowing the adding of new fields when needed.

The Vehicle configuration **530** is therefore comprised of sub-configurations (**532-538**) where each sub-configuration is used by a different subsystem. The signal catalog **532** is applied by the signal service **454,** the software configuration **534** is absorbed by other components. The hardware configuration **536** may be applied to the virtual environment **452.** The configuration is extensible, as shown at block **538,** such that additional system components can have an associated configuration applied as part of the emulation.

In order to encourage a broad catalog, the vehicle configurations in the configuration catalog **472** may come from a variety of sources. For example, developers for the original equipment manufacturer **550** may provide configurations. Other system developers **552** may provide configurations. Various vehicle or synthetic system partners **554** may provide configurations. Other users **556** may also provide configurations. The present disclosure is not limited to the entity or person providing the vehicle configurations.

Referring again to the embodiment of **Figure 4****,** the edge emulation node **430** may request a vehicle configuration at message **464** in order to retrieve the particular configuration for the vehicle on which the synthetic sensor is being tested. This information may be provided to the configuration loader **446** which may then be used to pre-configure the virtual environment at block **452,** configure the OS at block **450** (which may include the OS and the version of the OS in some cases), and configurate the signals and the sensor implementations at blocks **434, 436** and **438** as well as the signal catalogue **440.**

After the edge emulation note **430** is configured, the development node **410** may then deploy synthetic sensors, shown at arrow **480.** The edge emulation node **430** can emulate the synthetic sensor and send playback signal data, shown at arrow **482.** Insights from the emulated synthetic sensor may be requested by the development node **410,** as shown with arrow **484,** and logs and metrics may be retrieved at the development node **410,** shown with arrow **486.**

In this way, the emulation node **430** may behave as much as possible as the real vehicle and provide a developer with confidence that the synthetic sensors and insights generated from synthetic sensors will work on the real vehicle. Further, the certification of software for a vehicle by an OEM may occur more easily as the simulation was performed using such catalogs and hardware configurations.

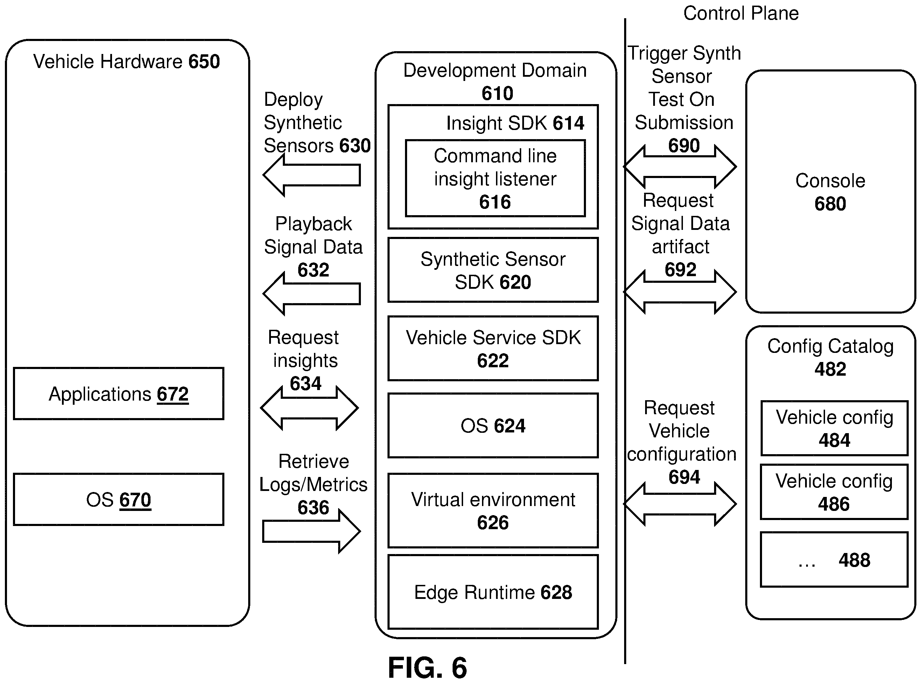

In a further embodiment, rather than use an emulation node, in some cases the actual hardware from a vehicle may be used when testing. In particular, the processor board from a vehicle may be used as part of the testing mechanism. In this regard, reference is now made to **Figure 6****.**

In the embodiment of **Figure 6****,** a development domain **610** includes the insight SDK **614,** the synthetic sensor SDK **620** and a vehicle service SDK **622.**

The insight SDK **614** may include a command line insight listener **616.**

Further, an operating system **624** may exist in the development domain.

Preconfigured virtual environment **626** may be used to obtain vehicle configuration information in the embodiment of **Figure 6****,** for example from configuration catalog **482.** This may be done, for example, using message **694.**

In the embodiment of **Figure 6****,** an edge runtime environment **628** may exist in order to provide signals to the hardware board **650.** However, in some embodiments this runtime environment may exist in a separate emulation node that interacts with the hardware and with the development node.

The hardware board **650** includes the applications **672** and the operating system **670** that would exist on the actual vehicle. For example, applications **672** may include the synthetic sensor systems described above.

The edge runtime **628** may trigger the synthetic sensor test on submission as shown with message **690** between the development domain **610** and the console **680.**

Further, the edge runtime **628** may request signal artifacts in message **692** from console **680.**

Once the runtime is configured, the development domain **610** may deploy the synthetic sensors as shown with message **630.** The development domain may then playback the signal data as shown with message **632** and may request insights as shown as message **634.**

Once the tests are finished, the logs and metrics may be retrieved as shown with message **636.**

Therefore, using the systems of **Figures 4** and **6****,** an environment is provided in which a developer may test the software on a cloud service configured to emulate the hardware, signals and software of the vehicle in the case of **Figure 4****,** or the actual hardware while using test data/signals configured for the vehicle in the console **680** the case of the embodiment of **Figure 6****.**

Further, libraries of configurations and libraries of signals that may be used for testing are provided, where real world signals and real world configurations for hardware, software and other configurations could be provided in the testing.

The system allows a user to choose an intended destination, and through the use of the configuration files and signal libraries the testing provides customized environments automatically, removing the burden of uploading the software onto an actual vehicle and the danger of testing a vehicle in a driving situation.

A loader can find out where the system is running and configure the emulator. In the case of running on actual hardware, the loader may only provide signals to use. If the cloud node is used, the loader may allow configuration of the hardware and the signals on the node to mimic the vehicle.

Once the configuration libraries and libraries of test data for vehicle configurations are set, a developer can specify which vehicle they want to test on. As the developer is ready to deploy the synthetic sensor, a simulation environment can be set up to mimic the test vehicle configuration and ingest data in a seamless way. In this way, the synthetic sensor can be validated using the desired configuration and test data without developers having to access the real vehicle or real data.

Further, the mechanism provides for third party developers to submit their synthetic sensors to vehicle OEMs and the OEMs can validate such submission automatically using their vehicle's configuration. This way the OEM can approve these solutions with confidence that the software will work on their vehicles.

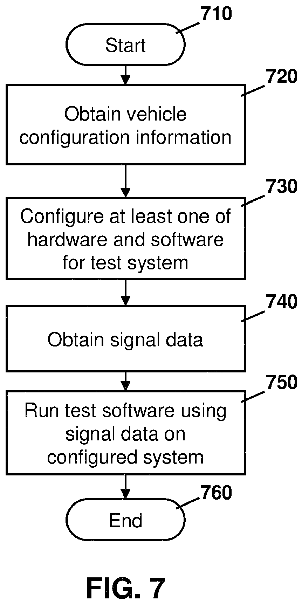

For example, reference is now made to **Figure 7****.** In the example of **Figure 7****,** the process starts at block **710** and proceeds to block **720** in which vehicle configuration information may be obtained. The vehicle configuration information may be software information, hardware information, a vehicle signal catalog, among other options.

The process then proceeds to block **730** in which at least one of hardware and software for the test system may be configured. If the system is running on a computing node, the hardware and software may be configured based on the information received at block **720.** If the system is running on actual hardware, then software at an emulation node may be configured to provide signal data, for example as provided at block **740.**

The system may then proceed to block **740** in which the test signal data may be obtained. For example, this may be obtained from the console **470** from the embodiment of **Figure 4** or console **680** from the embodiment of **Figure 6****.**

The process then proceeds to block **750** in which the test software such as the new synthetic sensor that is being developed, may be run on a system using the signal data obtained a block **740** and the configured system that was configured at block **730.**

The process then proceeds to block **760** and ends.

### Hardware

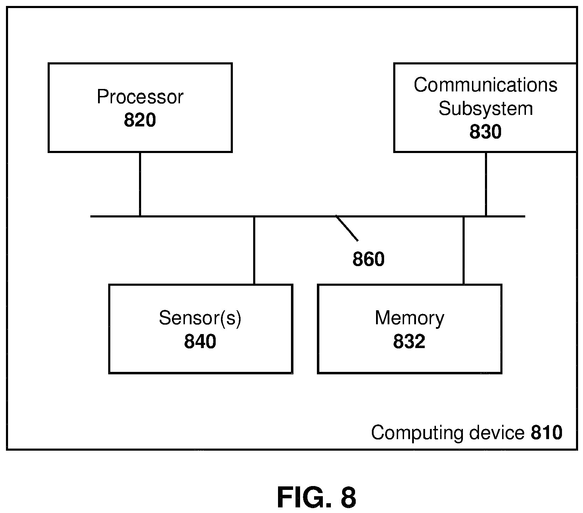

The above nodes, domains, computing devices, platforms, electronic control units, or other computing systems may be implemented using any computing device. One simplified diagram of a computing device is shown with regard to **Figure 8****.** The computing device of **Figure 8** could be any fixed or mobile computing device.

In **Figure 8****,** device **810** includes a processor **820** and a communications subsystem **830,** where the processor **820** and communications subsystem **830** cooperate to perform the methods of the embodiments described above. Communications subsystem **830** allows device **810** to communicate with other devices or network elements and may vary based on the type of communication being performed. Further, communications subsystem **830** may comprise a plurality of communications technologies, including any wired or wireless communications technology.

Processor **820** is configured to execute programmable logic, which may be stored, along with data, on device **810,** and shown in the example of **Figure 8** as memory **832.** Memory **832** can be any tangible, non-transitory computer readable storage medium which stores instruction code that, when executed by processor **820** cause device **810** to perform the methods of the present disclosure. The computer readable storage medium may be a tangible or in transitory/non-transitory medium such as optical (e.g., CD, DVD, etc.), magnetic (e.g., tape), flash drive, hard drive, or other memory known in the art.

Alternatively, or in addition to memory **832,** device **810** may access data or programmable logic from an external storage medium, for example through communications subsystem **830.**

In the example of **Figure 8****,** one or more sensors **840** may be associated with the computing device. However, this is optional and, in some cases, computing device **810** will not be associated with sensors.

Communications between the various elements of device **810** may be through an internal bus **860** in one embodiment. However, other forms of communication are possible.

The embodiments described herein are examples of structures, systems or methods having elements corresponding to elements of the techniques of this application. This written description may enable those skilled in the art to make and use embodiments having alternative elements that likewise correspond to the elements of the techniques of this application. The intended scope of the techniques of this application thus includes other structures, systems or methods that do not differ from the techniques of this application as described herein, and further includes other structures, systems, or methods with insubstantial differences from the techniques of this application as described herein.

While operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be employed. Moreover, the separation of various system components in the implementation descried above should not be understood as requiring such separation in all implementations, and it should be understood that the described program components and systems can generally be integrated together in a single software product or packaged into multiple software products.

Also, techniques, systems, subsystems, and methods described and illustrated in the various implementations as discrete or separate may be combined or integrated with other systems, modules, techniques, or methods. Other items shown or discussed as coupled or directly coupled or communicating with each other may be indirectly coupled or communicating through some interface, device, or intermediate component, whether electrically, mechanically, or otherwise. Other examples of changes, substitutions, and alterations are ascertainable by one skilled in the art and may be made.

While the above detailed description has shown, described, and pointed out the fundamental novel features of the disclosure as applied to various implementations, it will be understood that various omissions, substitutions, and changes in the form and details of the system illustrated may be made by those skilled in the art. In addition, the order of method steps are not implied by the order they appear in the claims.

When messages are sent to/from an electronic device, such operations may not be immediate or from the server directly. They may be synchronously or asynchronously delivered, from a server or other computing system infrastructure supporting the devices/methods/systems described herein. The foregoing steps may include, in whole or in part, synchronous/asynchronous communications to/from the device/infrastructure. Moreover, communication from the electronic device may be to one or more endpoints on a network. These endpoints may be serviced by a server, a distributed computing system, a stream processor, etc. Content Delivery Networks (CDNs) may also provide may provide communication to an electronic device. For example, rather than a typical server response, the server may also provision or indicate a data for content delivery network (CDN) to await download by the electronic device at a later time, such as a subsequent activity of electronic device. Thus, data may be sent directly from the server, or other infrastructure, such as a distributed infrastructure, or a CDN, as part of or separate from the system.

Typically, storage mediums can include any or some combination of the following: a semiconductor memory device such as a dynamic or static random access memory (a DRAM or SRAM), an erasable and programmable read-only memory (EPROM), an electrically erasable and programmable read-only memory (EEPROM) and flash memory; a magnetic disk such as a fixed, floppy and removable disk; another magnetic medium including tape; an optical medium such as a compact disk (CD) or a digital video disk (DVD); or another type of storage device. Note that the instructions discussed above can be provided on one computer-readable or machine-readable storage medium, or alternatively, can be provided on multiple computer-readable or machine-readable storage media distributed in a large system having possibly a plurality of nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In the foregoing description, numerous details are set forth to provide an understanding of the subject disclosed herein. However, implementations may be practiced without some of these details. Other implementations may include modifications and variations from the details discussed above. It is intended that the appended claims cover such modifications and variations.

## Claims

1. A method at a computing device comprising:
receiving an indication of a desired test environment;
accessing a configuration catalog to obtain configuration information for the desired test environment;
configuring a test node based on the configuration information;
obtaining test signals for the desired test environment; and
performing testing on the configured test node using the test signals.

2. The method of claim 1, wherein the configuration information includes at least one of a hardware configuration, software configuration, and signal configuration.

3. The method of claim 2, wherein the desired test environment is a vehicle configuration.

4. The method of any preceding claim, wherein the configuring the test node comprises selecting an operating system on the test node to match an operating system for the desired test environment.

5. The method of any preceding claim, wherein the configuring the test node comprises selecting hardware on the test node to match hardware for the desired test environment.

6. The method of any preceding claim, wherein the receiving the indication is based on a selection of a vehicle make and model at a development node.

7. The method of any preceding claim, wherein the test signals are real world signals for a vehicle performing tasks.

8. The method of any preceding claim, wherein the performing testing comprises:
installing a synthetic sensor at the test node, the synthetic sensor providing insights on the operation of the test node;
applying the test signals; and
providing logs and metrics to a developer node.

9. The method of any preceding claim, wherein the test node is an emulator interacting with hardware, and wherein the configuring comprises setting a signal configuration for interacting with the hardware.

10. A computing device comprising:
a processor; and
a communications subsystem,
wherein the computing device is configured to carry out the method of any preceding claim.

11. A computer program, which, when executed by a processor of a computing device causes the computing device to carry out the method of any one of claims 1 to 9.
